(19) **Europäisches Patentamt**
**European Patent Office**
**Office européen des brevets**

(11) **EP 4 779 063 A1**

(12) **EUROPEAN PATENT APPLICATION**

(43) Date of publication:
**22.07.2026   Bulletin 2026/30**

(21) Application number: **25223638.5**

(22) Date of filing: **16.12.2025**

(51) International Patent Classification (IPC):
***C30B 23/00*** *(2006.01)*     ***C30B 23/06*** *(2006.01)*
***C30B 29/36*** *(2006.01)*

(52) Cooperative Patent Classification (CPC):
**C30B 29/36; C30B 23/002; C30B 23/06**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **15.01.2025   EP 25152093**

(71) Applicant: **SiCrystal GmbH**
**90411 Nürnberg (DE)**

(72) Inventors:
• **Ecker, Bernhard**
 **90411 Nürnberg (DE)**
• **Elitzer, Daniel**
 **90411 Nürnberg (DE)**
• **Vogel, Michael**
 **90411 Nürnberg (DE)**
• **Wohlfart, Andreas**
 **90411 Nürnberg (DE)**

(74) Representative: **Rau, Schneck & Hübner**
**Patentanwälte Rechtsanwälte PartGmbB**
**Königstraße 2**
**90402 Nürnberg (DE)**

(54) **PROCESS FOR PRODUCING AN SIC BULK MONOCRYSTAL WITH AN ANNEALING AND COOLING PHASE AND MONOCRYSTALLINE CIRCULAR-CYLINDRICAL SIC BASE BODY**

(57)     The process is intended for producing at least one SiC bulk monocrystal (24) by sublimation growth. Prior to the start of the growth, at least one SiC seed crystal (8) is arranged in at least one crystal growth region (5) of a growth crucible (3), and SiC source material (6) is introduced into an SiC reservoir region (4) of the growth crucible (3). During a growth phase an SiC growth gas phase (9) is generated in the at least one crystal growth region (5) by sublimating the SiC source material (6) and transporting the sublimated gaseous components there, and the at least one SiC bulk monocrystal (24) having a central crystal longitudinal axis (14) grows on the at least one SiC seed crystal (8) by deposition from the SiC growth gas phase (9). During an annealing and cooling phase, carried out in the growth crucible after the growth phase is complete, the previously grown at least one SiC bulk monocrystal (24) is cooled, an axial cooling temperature gradient measured in the direction of the central crystal longitudinal axis (14) being provided within the at least one SiC bulk monocrystal (24), and an axial quotient of the axial cooling temperature gradient and an axial growth temperature gradient, prevailing within the at least one grown SiC bulk monocrystal (24) at the end of the previous growth phase and also measured in the direction of the central crystal longitudinal axis (14), having at most an axial comparison value of 0.4.

Fig. 2

**Description**

The contents of European patent application EP 25 152 093.8 are incorporated by reference.

The invention relates to a process for producing at least one SiC bulk monocrystal by sublimation growth and to a monocrystalline SiC base body.

The semiconductor material silicon carbide (SiC) is used, among other things, as a starting material for power electronic semiconductor components, high-frequency components, and special light-emitting semiconductor components, by virtue of its outstanding physical, chemical, electrical and optical properties. These components require SiC substrates (SiC wafers) having the largest possible substrate diameter and the highest possible quality.

The basis for the SiC substrates is high-quality SiC bulk monocrystals, which are generally produced by physical vapour deposition (PVT), in particular by a (sublimation) process described for example in US 8,865,324 B2. In this growth process, a monocrystalline SiC wafer as the SiC seed crystal is placed in a growth crucible along with suitable source material. Under controlled temperature and pressure conditions, the source material is sublimated, and the gaseous species are deposited on the SiC seed crystal, in such a way that the SiC bulk monocrystal grows there.

Monocrystalline SiC substrates in the form of wafers are subsequently cut out from the SiC bulk monocrystal, for example using a thread saw or a similar process, and, after multi-stage surface finishing, in particular through a plurality of polishing steps, are coated with at least one thin monocrystalline epitaxial layer, for example of SiC or GaN (gallium nitride), as part of the component manufacture. Defects from the SiC substrate are generally transferred to the applied epitaxial layer. The properties of the epitaxial layer, and thus ultimately also those of the components manufactured from it, depend critically on the quality of the SiC substrate or the underlying SiC bulk monocrystal.

The quality of the SiC substrate depends, among other things, on the stresses acting on the SiC bulk monocrystal during crystal growth. These stresses can cause the SiC substrates manufactured from the SiC bulk monocrystal to exhibit bowing and/or warping, resulting in a lower-quality and/or lower-yield epitaxy process.

Therefore, after their growth, SiC bulk monocrystals are conventionally subjected to thermal post-treatment (annealing) to heal or at least reduce stresses within the SiC crystal lattice and thus improve the crystal quality. A thermal post-treatment process of this type is described for example in DE 10 2009 048 868 B4. After its growth, the SiC bulk monocrystal is annealed in a separate annealing crucible during a subsequent additional process step, where it is completely embedded in SiC powder. During the thermal post-treatment, the temperature field within the SiC bulk monocrystal is as isothermal and homogeneous as possible. Preferably, a minimum possible temperature difference of at most 2 K, as measured along the longitudinal axis of the SiC bulk monocrystal (axially), is set so as to promote equalisation of mechanical stresses in the axial direction.

US 8,449,671 B2 describes a further process for thermal post-treatment of an SiC bulk monocrystal, which is also intended to reduce stresses within the SiC crystal lattice. During this post-treatment, which is also carried out in a separate annealing crucible, the SiC bulk monocrystal is subjected to an axial temperature gradient in the opposite direction from the axial temperature gradient established during the preceding actual crystal growth.

The additional thermal post-treatment in a separate annealing crucible, which has thus far been conventional for healing stresses in the SiC crystal lattice, is expensive and time-consuming.

The object of the invention is to provide an improved process for producing an SiC bulk monocrystal and an improved monocrystalline SiC base body by comparison with the known solutions.

To achieve the object relating to the process, a process according to the features of Claim 1 is set out. The process according to the invention is one for producing at least one SiC bulk monocrystal by sublimation growth, wherein, prior to the start of the growth, at least one SiC seed crystal is arranged in at least one crystal growth region of a growth crucible, and SiC source material is introduced into an SiC reservoir region of the growth crucible, during a growth phase an SiC growth gas phase is generated in the at least one crystal growth region by sublimating the SiC source material and transporting the sublimated gaseous components there, and the at least one SiC bulk monocrystal having a central crystal longitudinal axis grows on the at least one SiC seed crystal by deposition from the SiC growth gas phase, and during an annealing and cooling phase, carried out in the growth crucible after the growth phase is complete, the previously grown at least one SiC bulk monocrystal is cooled, an axial cooling temperature gradient measured in the direction of the central crystal longitudinal axis being provided within the at least one SiC bulk monocrystal, and an axial quotient of the axial cooling temperature gradient and an axial growth temperature gradient, prevailing within the at least one grown SiC bulk monocrystal at the end of the preceding growth phase and also measured in the direction of the central crystal longitudinal axis, having at most an axial comparison value of 0.4.

The axial cooling temperature gradient $(\text{grad } T)_{ax\_cool}$ and the axial growth temperature gradient $(\text{grad } T)_{ax\_grow}$ are each the first derivative of the relevant temperature with respect to the spatial coordinate in the direction of the central crystal longitudinal axis, in other words with respect to the axial spatial coordinate. The axial cooling temperature gradient $(\text{grad } T)_{ax\_cool}$ is in particular the dividend of the axial quotient, and the axial growth temperature gradient $(\text{grad } T)_{ax\_grow}$ is in particular the divisor. Therefore:

$$\frac{(\text{grad T})_{ax\_cool}}{(\text{grad T})_{ax\_grow}} \leq 0.4 \qquad\qquad (1a)$$

or

$$(\text{grad T})_{ax\_cool} \leq 0.4 \cdot (\text{grad T})_{ax\_grow} \qquad\qquad (1b).$$

In other words, the axial cooling temperature gradient $(\text{grad T})_{ax\_cool}$ is at most 40% of the axial growth temperature gradient $(\text{grad T})_{ax\_grow}$ prevailing within the at least one grown SiC bulk monocrystal at the end of the preceding growth phase. The axial cooling temperature gradient $(\text{grad T})_{ax\_cool}$ and the axial growth temperature gradient $(\text{grad T})_{ax\_grow}$ to be compared with it are in particular each located at the same position within the at least one SiC bulk monocrystal. Furthermore, the aforementioned relationship between the axial cooling temperature gradient $(\text{grad T})_{ax\_cool}$ and the axial growth temperature gradient $(\text{grad T})_{ax\_grow}$ preferably also applies at every position within the at least one SiC bulk monocrystal.

During its growth, the at least one SiC bulk monocrystal is grown in the axial direction. In the context of the process according to the invention, "axial" refers to a direction parallel to or along the central crystal longitudinal axis, "radial" to a direction perpendicular thereto, and "tangential" to a circumferential direction around the central crystal longitudinal axis.

It has been found that the quality of an SiC substrate subsequently obtained from the at least one SiC bulk monocrystal depends, among other things, on stresses which may act on the SiC bulk monocrystal during the crystal growth process, not only during the actual growth phase but also during the cooling phase, when the grown SiC bulk monocrystal is cooled in the growth crucible, in particular to room temperature. These stresses can lead to bowing and/or warping of the SiC substrates produced from the SiC bulk monocrystal and/or to dislocations within the SiC crystal lattice. Each of these effects reduces the quality of an SiC substrate. In particular, basal plane dislocations (BPDs) may occur, and can be caused by the relaxation of stresses within the SiC crystal lattice of the grown SiC bulk monocrystal, for example during the cooling phase.

There are various causes of stresses in the SiC crystal lattice, such as the unit used for growth, consisting of the SiC seed crystal and the associated seed holder, or differing thermal expansion coefficients between the wall of the growth crucible and the lateral circumferential edge of the SiC bulk monocrystal, opposite and in particular in contact with the wall, or the temperature gradients necessary for crystal growth during the actual growth phase, or indeed the temperature gradients prevailing during the cooling phase, which are the focus here. In this regard, in particular a reduction in the previously conventional temperature gradients is implemented during the annealing and cooling phase after the end of growth. Preferably, lower temperature gradients are set than was previously conventional.

In the physical vapour deposition (PVT) process used to grow the at least one SiC bulk monocrystal, the vaporised SiC source material is transported via an axial temperature gradient to the SiC seed crystal or to the growing SiC bulk monocrystal, where it is deposited and grows as a monocrystalline material. As the growth period progresses, the distance between the SiC source material and the growth interface of the growing SiC bulk monocrystal changes. This results in an axial change in the temperature field within the SiC bulk monocrystal along its growth direction, potentially leading to stresses within the SiC bulk monocrystal.

Similarly, a radial temperature gradient is established and defines the growth interface of the growing crystal. A higher temperature is set at the edge of the growing SiC bulk monocrystal than in the centre of the crystal, in particular to prevent intrusions from the edge. The SiC bulk monocrystal thus grows slightly faster in the centre than at its edge.

Both the axial and the radial temperature gradient are necessary for growing SiC bulk monocrystals by the PVT process. However, these two temperature gradients have not only the desired positive effects but also negative influences on the quality of the grown SiC bulk monocrystals and the SiC substrates produced therefrom. In relation to the growth interface of the SiC bulk monocrystal, an SiC substrate separated from an SiC bulk monocrystal consists of regions of the SiC bulk monocrystal which grew at different times. Overall, the growing SiC bulk monocrystal is exposed to a constantly changing temperature profile, and this can increase the stress state in the SiC crystal lattice. Furthermore, at the high temperatures prevailing during crystal growth, redistribution processes may occur in the SiC crystal lattice, which are caused by lattice stresses and lead to the formation of dislocations, in particular basal plane dislocations.

After the actual growth phase is complete, the entire growth arrangement, including the at least one previously grown SiC bulk monocrystal in the growth crucible, is cooled to room temperature before the SiC bulk monocrystal can be removed. During the cooling process, large amounts of heat are dissipated to the exterior from the growth arrangement in the axial and the radial direction. Heat is also dissipated via the at least one SiC bulk monocrystal in both the axial and the radial direction. During the cooling process, until a certain temperature, stresses can still be generated, redistributed, or even transformed into dislocations, in particular basal plane dislocations.

It has been found that cooling the at least one SiC bulk monocrystal with an axial cooling temperature gradient $(\text{grad T})_{ax\_cool}$ of at most 40% of the axial growth temperature gradient $(\text{grad T})_{ax\_grow}$ prevailing within the at least one grown SiC bulk monocrystal at the end of the preceding growth phase results in the at least one SiC bulk monocrystal exhibiting preferably a homogenised and in particular also a low stress state and a homogenised and in particular also a low basal plane dislocation state along its entire axial length. The process according to the invention preferably includes stress- and dislocation-reducing *in situ* annealing during the cooling phase, in other words annealing still carried out in the growth crucible after the end of the growth phase. This results in a high-quality SiC bulk monocrystal, from which high-quality SiC substrates having a low degree of bow, warp and basal plane dislocations can be manufactured. In particular, these advantageous effects are achieved without any additional thermal post-treatment in a separate annealing crucible. The annealing and cooling phase according to the invention, with the aforementioned low axial cooling temperature gradient $(\text{grad T})_{\text{ax\_cool}}$ and the slow cooling rate which in particular results from this, can therefore advantageously replace additional thermal treatment in a downstream process. The cooling time from the growth temperature to room temperature during the annealing and cooling phase, with the aforementioned low axial cooling temperature gradient $(\text{grad T})_{\text{ax\_cool}}$, is in particular at least 20%, preferably at least 30%, longer than a conventional cooling time without the aforementioned low axial cooling temperature gradient $(\text{grad T})_{\text{ax\_cool}}$.

Because of the *in situ* annealing of the at least one grown SiC bulk monocrystal during the cooling phase, the process according to the invention is very efficient and, at the same time, more cost-effective than the previously conventional additional thermal post-treatments in separate annealing crucibles. In particular, the process according to the invention makes it possible to produce a single SiC bulk monocrystal, but preferably also to produce two, three, four, five, six, seven, eight, nine, ten, or even more SiC bulk monocrystals simultaneously.

Advantageous embodiments of the process according to the invention will be apparent from the features of the claims dependent on Claim 1.

In one advantageous embodiment, the axial cooling temperature gradient is provided in such a way that the axial quotient of the axial cooling temperature gradient and the axial growth temperature gradient prevailing within the at least one grown SiC bulk monocrystal at the end of the preceding growth phase has at most an axial comparison value of 0.3. Therefore:

$$\frac{(\text{grad T})_{\text{ax\_cool}}}{(\text{grad T})_{\text{ax\_grow}}} \leq 0.3 \qquad\qquad (2a)$$

or

$$(\text{grad T})_{\text{ax\_cool}} \leq 0.3 \cdot (\text{grad T})_{\text{ax\_grow}} \qquad\qquad (2b).$$

In other words, the axial cooling temperature gradient $(\text{grad T})_{\text{ax\_cool}}$ is at most 30% of the axial growth temperature gradient $(\text{grad T})_{\text{ax\_grow}}$ prevailing within the at least one grown SiC bulk monocrystal at the end of the preceding growth phase. Because of the even lower axial cooling temperature gradient $(\text{grad T})_{\text{ax\_cool}}$ and the resulting even longer duration of the annealing and cooling phase, the stresses and dislocations, in particular basal plane dislocations, present in the crystal lattice of the at least one SiC bulk monocrystal at the end of the annealing and cooling phase are further reduced and also homogenised. The resulting at least one SiC bulk monocrystal and the SiC substrates produced therefrom are then even higher-quality.

In a further advantageous embodiment, the axial cooling temperature gradient is provided in such a way that the axial quotient of the axial cooling temperature gradient and the axial growth temperature gradient in each 1 cm³ sub-volume within the at least one SiC bulk monocrystal is at most the axial comparison value. This further promotes the homogenisation of the stress state and the (basal plane) dislocation state. The comparison condition between the axial cooling temperature gradient $(\text{grad T})_{\text{ax\_cool}}$ and the axial growth temperature gradient $(\text{grad T})_{\text{ax\_grow}}$:

$$(\text{grad T})_{\text{ax\_cool}} \leq C_{\text{ax\_max}} \cdot (\text{grad T})_{\text{ax\_grow}} \qquad\qquad (3),$$

where $C_{\text{ax\_max}}$ stands for the axial comparison value of the axial quotient, which is in particular 0.4 or 0.3, is in particular satisfied everywhere within the at least one SiC bulk monocrystal.

In a further advantageous embodiment, the axial cooling temperature gradient is provided in such a way that it is at least 2 K/cm and in particular at most 6 K/cm. Such low values of the axial cooling temperature gradient are particularly advantageous for a good annealing effect during the annealing and cooling phase.

A minimal axial cooling temperature gradient, in particular an axial cooling temperature gradient of at least 2 K/cm, is particularly advantageous. It ensures that homogenization of the SiC bulk monocrystal takes place in a directed manner. In particular, relaxations and/or dislocations, in particular basal plane dislocations, can propagate through the SiC bulk monocrystal in directed manner. Particularly advantageous, the amount of and/or distribution of remaining dislocations, in particular basal plane dislocations, can be adjusted. For example, dislocations can be propagated to specific regions of the SiC bulk monocrystal, leading to particularly low dislocation densities in regions of the SiC bulk monocrystal from which monocrystalline SiC substrates are to be separated. Additionally or alternatively, a specific distribution of the dislocations, in particular a homogenous distribution and/or a gradient of the density of dislocations, can be achieved. For example, the density of dislocations, in particular a basal plane dislocation density, can be adjusted to continuously increase from one axial end face to the other axial end face of the SiC bulk monocrystal.

In a further advantageous embodiment, during the annealing and cooling phase a radial cooling temperature gradient measured perpendicular to the central crystal longitudinal axis is provided within the at least one SiC bulk monocrystal, and a radial quotient of the radial cooling temperature gradient and a radial growth temperature gradient prevailing within the at least one grown SiC bulk monocrystal at the end of the preceding growth phase and also measured perpendicular to the central crystal longitudinal axis has a radial comparison value of at most 0.4 and in particular a radial comparison value of at most 0.3. The radial cooling temperature gradient $(\text{grad T})_{\text{rad\_cool}}$ and the radial growth temperature gradient $(\text{grad T})_{\text{rad\_grow}}$ are each the first derivative of the relevant temperature with respect to the spatial coordinate perpendicular to the central crystal longitudinal axis, in other words with respect to the radial spatial coordinate. The radial cooling temperature gradient $(\text{grad T})_{\text{rad\_cool}}$ is in particular the dividend of the radial quotient, and the radial growth temperature gradient $(\text{grad T})_{\text{rad\_grow}}$ is in particular the divisor. Therefore:

$$\frac{(\text{grad T})_{\text{rad\_cool}}}{(\text{grad T})_{\text{rad\_grow}}} \leq C_{\text{rad\_max}} \qquad\qquad (4a)$$

or

$$(\text{grad T})_{\text{rad\_cool}} \leq C_{\text{rad\_max}} \cdot (\text{grad T})_{\text{rad\_grow}} \qquad\qquad (4b),$$

where $C_{\text{rad\_max}}$ represents the radial comparison value of the radial quotient, which is in particular 0.4 or preferably 0.3. In other words, the radial cooling temperature gradient $(\text{grad T})_{\text{rad\_cool}}$ is at most 40%, in particular at most 30%, of the radial growth temperature gradient $(\text{grad T})_{\text{rad\_grow}}$ prevailing within the at least one grown SiC bulk monocrystal at the end of the preceding growth phase. The radial cooling temperature gradient $(\text{grad T})_{\text{rad\_cool}}$ and the radial growth temperature gradient $(\text{grad T})_{\text{rad\_grow}}$ to be compared with it are in particular each located at the same position within the at least one SiC bulk monocrystal. The aforementioned relationship between the radial cooling temperature gradient $(\text{grad T})_{\text{rad\_cool}}$ and the radial growth temperature gradient $(\text{grad T})_{\text{rad\_grow}}$ preferably also applies at every point within the at least one SiC bulk monocrystal. The low radial cooling temperature gradient $(\text{grad T})_{\text{rad\_cool}}$ also contributes to further reducing and also homogenising the stresses and dislocations, in particular basal plane dislocations, present in the crystal lattice of the at least one SiC bulk monocrystal at the end of the annealing and cooling phase. The resulting at least one SiC bulk monocrystal and the SiC substrates produced therefrom are then of particularly high quality.

In a further advantageous embodiment, the radial cooling temperature gradient is provided in such a way that the radial quotient of the radial cooling temperature gradient and the radial growth temperature gradient in each 1 cm³ sub-volume within the at least one SiC bulk monocrystal is at most the radial comparison value. This further promotes the homogenisation of the stress state and the (basal plane) dislocation state. The comparison condition between the radial cooling temperature gradient $(\text{grad T})_{\text{rad\_cool}}$ and the radial growth temperature gradient $(\text{grad T})_{\text{rad\_grow}}$ according to the preceding equation (4a) or (4b) is in particular satisfied everywhere within the at least one SiC bulk monocrystal.

In a further advantageous embodiment, the radial cooling temperature gradient is provided in such a way that it is at least 0.25 K/cm and in particular at most 2 K/cm. Such low values of the radial cooling temperature gradient are particularly advantageous for a good annealing effect during the annealing and cooling phase.

Advantageously, a minimal radial cooling temperature gradient allows for a directed homogenization, in particular directed propagation of dislocations, in the radial direction.

In a further advantageous embodiment, a central crystal length of 30 mm to 60 mm, in particular of 35 mm to 50 mm, measured along the central crystal longitudinal axis, is provided for the at least one SiC bulk monocrystal.

In a further advantageous embodiment, after the growth phase is complete, as a measure to reduce stresses within the previously grown at least one SiC bulk monocrystal, the previously used growth arrangement is modified by placing an additional cover adjacent to the end face of a growth insulation surrounding the growth crucible and in particular on the side of the growth insulation facing away from the growth crucible. In particular, the additional cover is moved to the desired position manually or automatically. Preferably, a corresponding control and adjustment mechanism is provided.

In particular, the additional cover is placed close to or over an insulation opening in the growth insulation located at an axial end face of the growth insulation. The additional cover may at least partially, in particular completely, cover the insulation opening.

The insulation opening is in particular located centrally at the end face and in particular extends completely through the growth insulation in the axial direction. A centrally located insulation opening is also referred to as central insulation opening.

The material of the additional cover may in particular be the same material as for the growth insulation, for example an insulating material made of or with carbon felt produced from carbon fibres or an insulating material made of or with a foam-like and/or porous carbon composite material, preferably with a foam-like and/or porous carbon matrix containing embedded carbon fibres. The additional cover is in particular configured as a thermally insulating element.

Preferably, the additional cover may have a thickness, wherein a ratio of the maximum value of the thickness of the additional cover to the thickness of the growth insulation, in particular the thickness of the growth insulation surrounding an, in particular central, insulation opening, is between 0.2 and 0.8. The thickness of the additional cover is in particular between 10 mm and 100 mm. The thickness is equal to the extent in the axial direction.

The additional cover has in particular a basic shape in the form of a preferably cylindrical plate. In particular, the additional cover may have a constant thickness in axial direction over its entire extension in radial direction.

It is also possible that the thickness in axial direction of the additional cover varies along the radial direction. For example, the thickness in axial direction may increase or decrease towards the centre of the additional cover. For example, the basic shape of the additional cover may be that of a truncated cone or a spherical cap.

It is also possible that the thickness in axial direction of the additional cover varies along the radial direction, wherein the additional cover comprises radial sections of different thickness in radial direction. For example, different radial sections of increasing, decreasing or constant thickness may be aligned in radial direction in any order.

A diameter of the additional cover may, preferably, be larger than a diameter of the, in particular central, insulation opening. The additional cap is easily placeable onto the growth insulation, in particular covering the insulation opening. Advantageously, the insulation opening can be completely covered, independent of positioning accuracy. For example, a ratio of the diameter of the additional cover to a diameter of the central insulation opening may be between 1.1 and 3.0, in particular between 1.5 and 2.5.

In particular because of its additional thermal insulation, the additional cover, applied for the annealing and cooling phase, advantageously causes the axial and/or radial cooling temperature gradients to be set to the desired low values. The additional cover is a measure which is simple to implement yet highly efficient for this purpose, and thus also for the advantageous annealing of the at least one SiC bulk monocrystal during its cooling to room temperature, with the desired reduction and homogenisation of the stress state and the (basal plane) dislocation state in the SiC crystal lattice.

The thickness of the additional cover, in particular its thickness in relation to the thickness of the growth insulation, and/or possible thickness variations along the radial direction provide adjustment parameters to tune the axial and/or the radial cooling temperature gradient.

In a further advantageous embodiment, the additional cover is placed directly adjacent to the growth insulation. Because the additional cover is then in direct contact with the growth insulation, this results in very low heat loss and therefore very high efficiency.

In a further advantageous embodiment, the additional cover is placed at a distance from the growth insulation. In particular, an axial distance of preferably between 1 mm and 10 mm is provided between the additional cover and the growth insulation. This is very easy to implement from a technical standpoint. The distance provides a further adjustment parameter for tuning the axial and/or radial cooling temperature gradient.

In a further advantageous embodiment, the additional cover is provided with a structure in which the additional cover has a central cover opening extending completely through the additional cover axially, and the central cover opening has a cross-sectional area having a quotient of in particular between 0.1 and 0.3 with the cross-sectional area of the, in particular central, insulation opening located at the end face of the growth insulation. The cross-sectional area of the central cover opening is the dividend, and the cross-sectional area of the insulation opening is the divisor of this quotient. In other words, the cross-sectional area of the central cover opening is in particular 10% to 30% of the cross-sectional area of the insulation opening. This provides an additional adjustment parameter for particularly simple and precise setting of the desired low values, but preferably above a respective minimal value, for the axial and/or radial cooling temperature gradients. The additional cover is preferably placed in such a way that the central cover opening and the insulation opening are arranged concentric with one other and in particular also with the central crystal longitudinal axis, and are preferably aligned with one another.

In a further advantageous embodiment, the additional cover is provided with a structure in which the additional cover has at least two cover openings extending completely through the additional cover axially, and each cover opening has an associated cross-sectional area, a quotient of the sum of the cross-sectional areas of all cover openings and the cross-sectional area of the, in particular central, insulation opening located at the end face of the growth insulation in particular being between 0.1 and 0.3. The sum of the cross-sectional areas of all cover openings is the dividend, and the cross-sectional area of the insulation opening is the divisor of this quotient. In other words, the sum of the cross-sectional areas of all cover openings is in particular 10% to 30% of the cross-sectional area of the insulation opening.

Optionally, one of the cover openings may be positioned in the centre of the additional cover, in other words may be a central cover opening. In particular, the cover openings, at least apart from the optional central cover opening, are uniformly distributed, for example uniformly distributed in a tangential direction. Preferably, the cover openings, at least apart from the optional central cover opening, may be arranged along a circle concentric with the central crystal longitudinal axis and in particular also rotationally symmetrical about the central crystal longitudinal axis.

In a further advantageous embodiment, between the growth phase and the annealing and cooling phase, an annealing and holding phase is carried out, during which an annealing and holding temperature is set which is at least as high as the growth temperature set during the growth phase and in particular is at most 250°C higher than the growth temperature. The annealing and holding phase further promotes the *in situ* annealing of the at least one SiC bulk monocrystal. It also contributes to further reducing and also homogenising the stresses and dislocations, in particular basal plane dislocations, present in the crystal lattice of the at least one SiC bulk monocrystal at the end of the annealing and cooling phase. The stress-reducing measures, such as placing the additional cover adjacent to the growth insulation at the end face, are implemented in particular before or during the annealing and holding phase.

To achieve the object relating to the monocrystalline SiC base body, a monocrystalline SiC base body corresponding to the features of Claim 15 is set out. The monocrystalline SiC base body according to the invention is produced from a sublimation-grown SiC bulk monocrystal and is intended for separating a plurality of monocrystalline SiC substrates from the monocrystalline SiC base body, the monocrystalline SiC base body having a shape which, at least in a sub-region, is that of a cylinder, in particular circular cylinder, and an upper monocrystalline SiC substrate, separable from the monocrystalline SiC base body at the upper end face, having an upper basal plane dislocation density, and a lower monocrystalline SiC substrate, separable from the monocrystalline SiC base body at the lower end face, having a lower basal plane dislocation density, the upper basal plane dislocation density and the lower basal plane dislocation density differing from one another by at most 25%, in particular by at most 20%, in particular by at most 15%. In particular, the upper basal plane dislocation density and the lower basal plane dislocation density may substantially coincide. It is possible that the upper and lower basal plane dislocation densities differ by at least 1%, in particular by at least 5%.

The monocrystalline SiC base body according to the invention is produced in particular by processing an SiC bulk monocrystal grown by the process described above or one of its advantageous embodiments. This processing may be carried out in particular by trimming and/or grinding and/or polishing individual or all edge faces. The monocrystalline SiC base body is in particular exactly circular-cylindrical. However, it may preferably also have an orientation marking, for example in the form of a flat partial edge face extending longitudinally along the monocrystalline SiC base body or a likewise longitudinally extending notch, resulting in the circular-cylindrical shape only being present in the sub-region outside the orientation marking in each case.

For example, the SiC bulk monocrystal has a central crystal length L along the axial direction (growth direction). The central crystal length L may be measured from the outer surface of the seed crystal to a tip of the growth interface. Let $x$ be a coordinate along the axial direction with origin in the outer surface of the seed crystal. A relative length coordinate $r_x$ of the SiC bulk monocrystal may be defined as: $r_x = x/L$. An axial position with the SiC bulk monocrystal may be described by the relative length coordinate $r_x$, wherein $0 \leq r_x \leq 1$.

Preferably, the monocrystalline SiC base body is obtained from a portion of the SiC bulk monocrystal with a relative length coordinate $r_x$ so that $0.2 \leq r_x \leq 0.8$, in particular one of the following ranges: $0.2 \leq r_x \leq 0.5$ or $0.25 \leq r_x \leq 0.5$ or $0.3 \leq r_x \leq 0.8$ or $0.4 \leq r_x \leq 0.8$ or $0.5 \leq r_x \leq 0.8$. This axial portions of the SiC bulk monocrystal were found to be particularly suitable for obtaining high quality monocrystalline SiC substrates. Smaller relative length coordinates (i.e. closer to the seed crystal) are often inflicted by still unstable growth conditions.

The monocrystalline SiC base body has in particular a central base body longitudinal axis. In connection with the monocrystalline SiC base body according to the invention and the monocrystalline SiC substrates separable from it, "axial" refers a direction parallel to or along this central base body longitudinal axis, "radial" to a direction perpendicular thereto, and "tangential" to a circumferential direction around the central base body longitudinal axis. The longitudinal direction of the monocrystalline SiC base body corresponds to the axial direction.

The upper monocrystalline SiC substrate, which can be separated from the monocrystalline SiC base body at the upper end face, and the lower monocrystalline SiC substrate, which can be separated from the monocrystalline SiC base body at the lower end face, each have in particular a thickness of 300 $\mu$m to 800 $\mu$m, the thickness indicating the extent in the axial direction.

Preferably, at least one intermediate monocrystalline SiC substrate, in particular a plurality of intermediate monocrystalline SiC substrates, can be separated from the monocrystalline SiC base body form an axial position between the upper and lower monocrystalline SiC substrate. In particular, 2, 3, 4, 5 or more intermediate monocrystalline SiC substrates can be separated from the monocrystalline SiC base body.

The monocrystalline SiC base body advantageously has a highly homogeneous basal plane dislocation distribution within its SiC crystal lattice. The upper basal plane dislocation density, in other words the basal plane dislocation density at its upper end face, differs only slightly from the lower basal plane dislocation density, in other words the basal plane dislocation density at its lower end face. In particular, a quotient of the upper basal plane dislocation density and the lower basal plane dislocation density is in the range between 0.75 and 1.25, in particular between 0.8 and 1.2, in particular between 0.85 and 1.15. This advantageous, largely homogeneous distribution of basal plane dislocations within the monocrystalline SiC base body is in particular due to the process by which the SiC bulk monocrystal underlying the monocrystalline SiC base body was produced. The annealing and cooling phase of the production process has a particularly advantageous effect on the highly homogeneous distribution of basal plane dislocations which ultimately arises within the monocrystalline SiC base body. The annealing and cooling phase, carried out in particular with the advantageous very low cooling temperature gradients and thus also in particular very slowly, prevents the formation of basal plane dislocations, which would otherwise occur during the cooling process and could then no longer be significantly healed or reversed by subsequent annealing in a separate annealing crucible. Monocrystalline SiC base body bodies having such a homogeneous distribution of the basal plane dislocations cannot be produced by conventional growth processes. This is only now possible with the process described above, having the advantageous annealing and cooling phase which combines the cooling process with a simultaneous annealing process which is still carried out in the growth crucible.

Preferably, the distribution of basal plane dislocations is homogenous throughout the entire monocrystalline SiC base body, in particular over its entire axial length.

In particular, the one or more intermediate monocrystalline SiC substrates each have an intermediate basal plane dislocation density. The intermediate basal plane dislocation density of any intermediate monocrystalline SiC substrate may differ only slightly form the basal plane dislocation density of the upper monocrystalline SiC substrate and/or lower monocrystalline SiC substrate, in particular by at most 25%, in particular by at most 20%, in particular by at most 15%. In particular, the intermediate basal plane dislocation density of one or more of the at least one intermediate monocrystalline SiC substrate may substantially coincide with the upper and/or lower basal plane dislocation density. It is possible that the intermediate basal plane dislocation density of one or more of the at least one intermediate monocrystalline SiC substrate may differ from the upper and/or lower basal plane dislocation densities by at least 1%, in particular by at least 5%.

For example, a quotient of the intermediate basal plane dislocation density of each intermediate monocrystalline SiC substrate and the upper lower basal plane dislocation density and/or a quotient of the intermediate basal plane dislocation density of each intermediate monocrystalline SiC substrate and the upper lower basal plane dislocation density is in the range between 0.75 and 1.25, in particular between 0.8 and 1.2, in particular between 0.85 and 1.15.

Preferably, the basal plane dislocation density may increase or decrease from the lower monocrystalline SiC substrate towards the upper monocrystalline SiC substrate. For example, the basal plane dislocation density may substantially linearly increase or substantially linearly decrease from the lower monocrystalline SiC substrate towards the upper monocrystalline SiC substrate. In particular, the basal plane dislocation density may decrease, in particular substantially linearly, from the lower monocrystalline SiC substrate towards the upper monocrystalline SiC substrate.

Particularly preferably, a gradient of the basal plane dislocation density may be monotone, in particular strictly monotone, along the axial direction. For example, the basal plane dislocation density may, in particular strictly, monotonically increase or, in particular strictly, monotonically decrease from the lower monocrystalline SiC substrate towards the upper monocrystalline SiC substrate.

Preferably, the basal plane dislocation density of the upper monocrystalline SiC substrate and/or of the lower monocrystalline SiC substrate and/or of the at least one intermediate monocrystalline SiC substrate, in particular of each monocrystalline SiC substrate separable from the monocrystalline SiC base body, may be $150/cm^2$ or less, in particular $125/cm^2$ or less, in particular $100/cm^2$ or less, in particular $75/cm^2$ or less, in particular $50/cm^2$ or less, in particular $25/cm^2$ or less, and, exemplarily, $5/cm^2$ or more, in particular $10/cm^2$ or more. For example, the basal plane dislocation density of the upper monocrystalline SiC substrate and/or of the lower monocrystalline SiC substrate and/or of the at least one intermediate monocrystalline SiC substrate, in particular of each monocrystalline SiC substrate separable from the monocrystalline SiC base body, may be between $150/cm^2$ and $5/cm^2$ or between $100/cm^2$ and $5/cm^2$ or between $50/cm^2$ and $5/cm^2$ or between $25/cm^2$ and $5/cm^2$ or between $150/cm^2$ and $10/cm^2$ or between $100/cm^2$ and $10/cm^2$ or between $50/cm^2$ and $10/cm^2$ or between $25/cm^2$ and $10/cm^2$.

Preferably, the intermediate basal plane dislocation density of each intermediate monocrystalline SiC substrate may, preferably, be between the upper basal plane dislocation density and the lower basal plane dislocation density.

In an exemplary embodiment, the lower monocrystalline SiC substrate may have a lower basal plane dislocation density of about $150/cm^2$ and the upper monocrystalline SiC substrate may have an upper basal plane dislocation density of about $112/cm^2$, in particular of about $120/cm^2$, in particular of about $130/cm^2$. The intermediate basal plane dislocation density of each intermediate monocrystalline SiC substrate may, preferably, be between the upper basal plane dislocation density and the lower basal plane dislocation density.

In an exemplary embodiment, the lower monocrystalline SiC substrate may have a lower basal plane dislocation density of about $50/cm^2$ and the upper monocrystalline SiC substrate may have an upper basal plane dislocation density of about $38/cm^2$, in particular of about $40/cm^2$, in particular of about $43/cm^2$. The intermediate basal plane dislocation density of each intermediate monocrystalline SiC substrate may, preferably, be between the upper basal plane dislocation density and the lower basal plane dislocation density.

In an exemplary embodiment, the lower monocrystalline SiC substrate may have a lower basal plane dislocation density of about $25/cm^2$ and the upper monocrystalline SiC substrate may have an upper basal plane dislocation density of

about 19/cm$^2$, in particular of about 20/cm$^2$, in particular of about 22/cm$^2$. The intermediate basal plane dislocation density of each intermediate monocrystalline SiC substrate may, preferably, be between the upper basal plane dislocation density and the lower basal plane dislocation density.

Otherwise, the monocrystalline SiC base body according to the invention and its advantageous embodiments have substantially the same advantages which were described above in connection with the production process according to the invention and its advantageous embodiments.

Advantageous embodiments of the monocrystalline SiC base body according to the invention are described in the following.

In one advantageous embodiment, the upper basal plane dislocation density and the lower basal plane dislocation density differ from one another by at most 20% and in particular by at most 15%. This results in a more homogeneous basal plane dislocation state.

In a further advantageous embodiment, the upper monocrystalline SiC substrate has a first bow and the lower monocrystalline SiC substrate has a second bow, the first bow and the second bow differing from one another by at most 25%, in particular by at most 20%, in particular by at most 15%. In particular, the first bow and the second bow may substantially coincide. It is possible that the first bow and the second bow differ by at least 1%, in particular by at least 5%.

"Bow" is an (English) technical term, also commonly used in other languages among experts, for a bending or deflection of the monocrystalline SiC substrate. "Bow" refers to the distance, at the centre of the free, unclamped monocrystalline SiC substrate, between a reference plane, in particular a three-point reference plane, and a surface of the monocrystalline SiC substrate. Instead of the surface of the monocrystalline SiC substrate, in particular a median surface extending within the free, unclamped monocrystalline SiC substrate and substantially parallel to the surface may also be used. Bow values can be positive or negative.

Preferably, the bow of each intermediate monocrystalline SiC substrate may differ from the first bow and/or the second bow by at most 25%, in particular by at most 20%, in particular by at most 15%. It is possible that the bow of an intermediate monocrystalline SiC may substantially coincide with the first bow and/or the second bow or may differ from the first bow and/or the second bow by at least 1%, in particular by at least 5%.

In a further advantageous embodiment, the upper monocrystalline SiC substrate has a first warp and the lower monocrystalline SiC substrate has a second warp, the first warp and the second warp differing from one another by at most 25%, in particular by at most 20%, in particular by at most 15%. In particular, the first warp and the second warp may substantially coincide. It is possible that the first warp and the second warp differ by at least 1%, in particular by at least 5%.

"Warp" is an (English) technical term, also commonly used in other languages among experts, for a curvature or bulge of the monocrystalline SiC substrate. "Warp" refers to the sum of the magnitude of the greatest distance of a surface of the free, unclamped monocrystalline SiC substrate from a reference plane, in particular a three-point reference plane, (= first summand) and the magnitude of the smallest distance of the surface of the free, unclamped monocrystalline SiC substrate from the reference plane (= second summand). Instead of the surface of the monocrystalline SiC substrate, in particular a median surface extending within the free, unclamped monocrystalline SiC substrate and substantially parallel to the surface may also be used. Warp values are always positive.

Preferably, the warp of each intermediate monocrystalline SiC substrate may differ from the first warp and/or the second warp by at most 25%, in particular by at most 20%, in particular by at most 15%. It is possible that the warp of an intermediate monocrystalline SiC may substantially coincide with the first warp and/or the second warp or may differ from the first warp and/or the second warp by at least 1%, in particular by at least 5%.

In a further advantageous embodiment, the monocrystalline SiC base body has a base body diameter of at least 150 mm, in particular at least 200 mm. Preferably, the base body diameter is 150 mm or approximately 200 mm. A current upper limit for the base body diameter, due to manufacturing constraints, is in particular approximately 300 mm, although larger base body diameters are also conceivable in principle. The base body diameter corresponds to the substrate diameter of monocrystalline SiC substrates separated from the monocrystalline SiC base body. The larger the base body diameter, and thus also the substrate diameter, the more efficiently monocrystalline SiC substrates separated from the monocrystalline SiC base body can subsequently be used, for example for producing semiconductor and/or high-frequency devices. This reduces the component production costs. A monocrystalline SiC substrate having such a large diameter can also advantageously be used to produce relatively large semiconductor and/or high-frequency components, which have for example a base area of approximately 1 cm$^2$.

In a further advantageous embodiment, the monocrystalline SiC base body has a central base body longitudinal axis which is tilted with respect to the surface normal of the basal plane of the crystal structure of the monocrystalline SiC base body, by a tilt angle which is in particular greater than 0° and preferably at most approximately 8°. Preferably, the tilt angle is approximately 4°. In particular, the monocrystalline SiC base body has an orientation which is tilted relative to the SiC crystal structure (= off-orientation). Preferably, the central base body longitudinal axis is tilted relative to the direction of the surface normal of the basal plane [0001] in the direction of the [11-20] crystal direction. The basal plane is in particular the (0001) plane of the SiC crystal structure. In the case of an off-orientation of the monocrystalline SiC base body relative to the SiC crystal structure, the central base body longitudinal axis of the monocrystalline SiC base body and the central crystal longitudinal axis of the SiC bulk monocrystal from which the monocrystalline SiC base body is produced in particular diverge. The central base body longitudinal axis and the central crystal longitudinal axis, which is orientated in the growth direction of the sublimation-grown SiC bulk monocrystal, are then in particular also tilted relative to one another by the tilt angle.

In a further advantageous embodiment, the monocrystalline SiC base body has a base body length of 20 mm to 60 mm, in particular 25 mm to 50 mm, as measured along its central base body longitudinal axis.

In a further advantageous embodiment, the monocrystalline SiC base body has an SiC crystal structure with only a single SiC polytype, in particular with one of the SiC polytypes 4H, 6H, 15R, and 3C. Preferably, there is a high modification stability, distinguished in particular by a near-absence of polytype transitions. If the monocrystalline SiC base body contains only a single SiC polytype, it advantageously also has a very low defect density. Very high-quality monocrystalline SiC substrates can then be separated from it. Polytype 4H is particularly preferred.

Further features, advantages and details of the invention will become apparent from the following description of example embodiments with reference to the drawings, in which:

Fig. 1　　shows an example embodiment of a growth arrangement for sublimation growth of an SiC bulk monocrystal,

Fig. 2 to 4　　show example embodiments of growth arrangements for sublimation growth of an SiC bulk monocrystal with a stress-reducing measure which can be switched on during an annealing and cooling phase,

Fig. 5　　shows an example embodiment of a growth arrangement for sublimation growth of two SiC bulk monocrystals with stress-reducing measures which can be switched on during an annealing and cooling phase, and

Fig. 6　　shows an example embodiment of a monocrystalline SiC base body produced from an SiC bulk crystal grown using a growth arrangement according to Fig. 2 to 5.

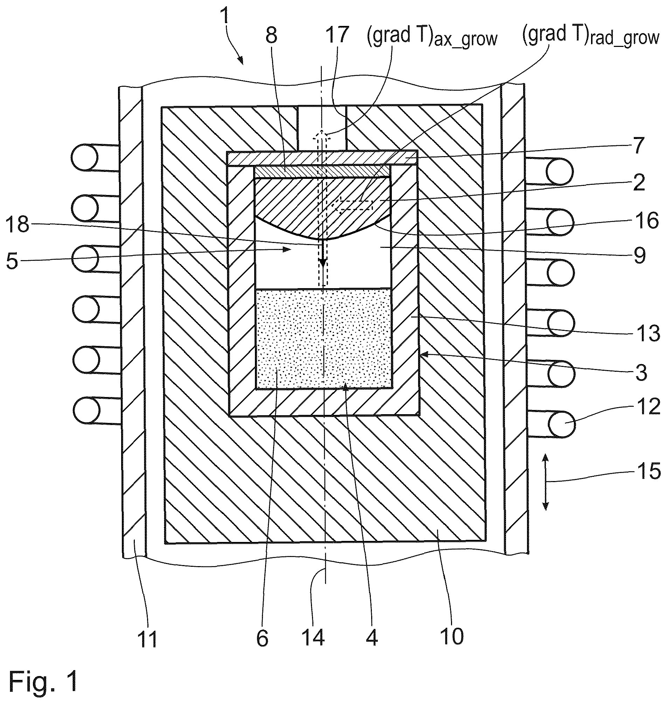

Corresponding parts are provided with like reference numerals in Fig. 1 to 6. Details of the example embodiments described in greater detail in the following may also constitute an invention in their own right or be part of an invention.

Fig. 1 shows an example embodiment of a growth arrangement 1 for producing an SiC bulk monocrystal 2 by sublimation growth. The growth arrangement 1 includes a growth crucible 3, which comprises an SiC reservoir region 4 and a crystal growth region 5. For example, there is powdered SiC source material 6 in the SiC reservoir region 4, which is placed in the SiC reservoir region 4 of the growth crucible 3 as a pre-prepared starting material before the growth process begins.

In the region of a crucible end wall 7 of the growth crucible 3, opposite the SiC reservoir region 4, an SiC seed crystal 8 extending axially into the crystal growth region 5 is attached. The SiC seed crystal 8 is in particular monocrystalline. In the example embodiment shown, the crucible end wall 7 is configured as the crucible lid of the growth crucible 3. However, this is not compulsory. The SiC bulk monocrystal 2 to be grown grows on the SiC seed crystal 8 by deposition from an SiC growth gas phase 9 which forms in the crystal growth region 5. The growing SiC bulk monocrystal 2 and the SiC seed crystal 8 have approximately the same diameter. The deviation, if any, by which the seed diameter of the SiC seed crystal 8 is less than the monocrystalline diameter of the SiC bulk monocrystal 2 is at most 10%. However, there may be a gap (not shown in Fig. 1) between the inside of a crucible side wall 13, on the one hand, and the growing SiC bulk monocrystal 2 and the SiC seed crystal 8, on the other hand.

In the example embodiment of Fig. 1, the growth crucible 3, including the crucible lid 7, consists of an electrically and thermally conductive graphite crucible material having a density of for example at least 1.75 g/cm$^3$. A thermal growth insulation 10 is arranged around it. Said insulation consists for example of an insulating material which is a foam-like carbon composite material, having a carbon matrix and embedded carbon fibres, and whose porosity is in particular much higher than that of the graphite crucible material.

The thermally insulated growth crucible 3 is placed inside a tubular container 11, which in this example embodiment is configured as a quartz glass tube and forms an autoclave or reactor. To heat the growth crucible 3, an inductive heating device in the form of a heating coil 12 is arranged around the container 11. The growth crucible 3 is heated to the temperatures required for growth by means of the heating coil 12. In the example embodiment shown, these growth temperatures are at least 2250°C. The heating coil 12 inductively couples an electric current into the electrically conductive crucible side wall 13 of the growth crucible 3. This electric current flows within the circular and hollow cylindrical crucible side wall 13 in the circumferential direction, substantially as a circular current, and thus heats the growth crucible 3. If necessary, the relative position between the heating coil 12 and the growth crucible 3 can be altered axially, in other words in the direction of a central crystal longitudinal axis 14 of the growing SiC bulk monocrystal 2, in particular so as to set and optionally also to alter the temperature or temperature progression within the growth crucible 3. The axially settable position of the heating coil 12 during the growth process is indicated by the double-headed arrow 15 in Fig. 1. In particular, the heating coil 12 is displaced in a manner matched to the growth progress of the growing SiC bulk monocrystal 2. The displacement is preferably downward, in other words in the direction of the SiC source material 6, and preferably of the same length by which the SiC bulk monocrystal 2 grows, for example approximately 20 mm in total. For this purpose, the growth arrangement 1 includes appropriately configured monitoring, control and adjustment means (not shown in greater detail).

The SiC growth gas phase 9 in the crystal growth region 5 is supplied by the SiC source material 6. The SiC growth gas phase 9 contains at least gaseous components in the form of Si, $Si_2C$ and $SiC_2$ (= SiC gaseous species). Material transport from the SiC source material 6 to a growth interface 16 on the growing SiC bulk monocrystal 2 takes place along an axial growth temperature gradient (grad T)$_{ax\_grow}$. In the sublimation process (= PVT process) used for SiC crystal growth, the growth conditions, including the material transport, are set and controlled by way of the temperatures prevailing in the growth crucible 3. At the growth interface 16, a relatively high growth temperature of at least 2250°C prevails, in particular even at least 2350°C or 2400°C. Furthermore, in particular an axial growth temperature gradient (grad T)$_{ax\_grow}$ of at least 5 K/cm, preferably at least 15 K/cm, as measured in the direction of the central crystal longitudinal axis 14, is established at the growth interface 16. The temperature within the growth crucible 3 decreases in the axial direction towards the growing SiC bulk monocrystal 2. The highest temperature, at approximately 2450°C to 2550°C, is located in the region of the SiC reservoir region 4. This temperature progression, with a temperature difference of in particular 100°C to 150°C between the SiC reservoir region 4 and the growth interface 16, can be achieved by various means. Axially varying heating can thus be provided by dividing (not shown in detail) the heating coil 12 into two or more axial portions. Furthermore, a stronger heating effect can be set in the lower portion of the growth crucible 3 than in the upper portion of the growth crucible 3, for example by appropriately axially positioning the heating coil 12. Moreover, the thermal insulation on the two axial crucible end walls may be configured differently. As is schematically indicated in Fig. 1, for this purpose the thermal growth insulation 10 may have a different axial thickness on the lower crucible end wall from on the upper crucible end wall. Furthermore, it is possible for the thermal growth insulation 10 to have a central cooling opening in the form of a central insulation opening 17, through which heat is dissipated, arranged around the central crystal longitudinal axis 14, at the end face, adjacent to the upper crucible end wall 7.

A temperature progression is also provided in the radial direction. A radial growth temperature gradient (grad T)$_{rad\_grow}$ is set in such a way that there is a higher temperature at the radial edge of the growing SiC bulk monocrystal 2 than in the centre of the growing SiC bulk monocrystal 2, in particular to prevent intrusions originating from the radial edge. The SiC bulk monocrystal 2 thus grows somewhat faster in the centre than at its radial edge. This results in the downwardly convex, cap-like shape of the growth interface 16 indicated in Fig. 1.

Moreover, during the actual crystal growth, there is a growth pressure of in particular 0.1 hPa (= mbar) to 10 hPa (= mbar) in the growth crucible 3.

The SiC bulk monocrystal 2 grows in a growth direction 18 which, in the example embodiment shown in Fig. 1, is orientated from top to bottom, in other words from the crucible lid 7 towards the SiC reservoir region 4. The growth direction 18 extends parallel to the central crystal longitudinal axis 14. Since the growing SiC bulk monocrystal 2 is arranged concentrically within the growth arrangement 1 in the example embodiment shown, the central crystal longitudinal axis 14 is also the central longitudinal axis of the growth arrangement 1.

The growing SiC bulk monocrystal 2 has an SiC crystal structure of the 4H polytype. In principle, however, a different polytype (= a different crystal modification), such as 6H-SiC, 3C-SiC or 15R-SiC, is also possible. Advantageously, the SiC bulk monocrystal 2 has only a single SiC polytype, which in the example embodiment is the aforementioned 4H-SiC. The SiC bulk monocrystal 2 grows with high modification stability and therefore substantially only has a single polytype. This is advantageous with a view to a high crystal quality with very few defects.

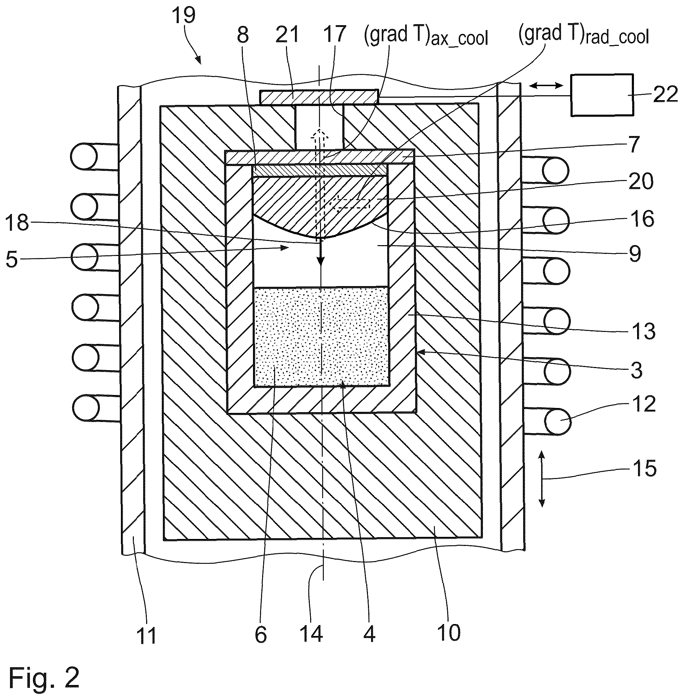

Fig. 2 shows an example embodiment of a further growth arrangement 19 for sublimation growth of an SiC bulk monocrystal 20. The growth arrangement 19 of Fig. 2 substantially differs from the growth arrangement 1 of Fig. 1 by way of an additional cover 21, which can be placed directly on the growth insulation 10, specifically on the side of the growth insulation 10 opposite the crucible end wall 7. The additional cover 21 consists of the same material as the growth insulation 10 and is in particular also a thermally insulating element. It is configured as a cylindrical plate and has an axial thickness of in particular between 10 mm and 100 mm. The additional cover 21 can be moved into its desired operating position on the end face of the growth insulation 10 by means of a control and adjustment mechanism 22. In this operating position, shown in Fig. 2, it covers the central insulation opening 17 and is arranged concentric with the central crystal longitudinal axis 14.

During the actual growth phase, the additional cover 21 is not in its operating position. In the growth arrangement 19, the actual growth phase takes place with a setup substantially identical to the growth arrangement 1 of Fig. 1, in other words without the additional cover 21. It is only moved into its operating position, shown in Fig. 2, after the actual growth phase is complete, where it then remains also during the subsequent annealing and cooling phase. During the annealing and cooling phase, the additional cover 21 is a means of reducing and homogenising stresses and/or basal plane dislocations within the grown SiC bulk monocrystal 19. It contributes to ensuring that, during the annealing and cooling phase, the axial cooling temperature gradient $(\text{grad } T)_{ax\_cool}$ is at most 40%, in particular at most 30%, of the axial growth temperature gradient $(\text{grad } T)_{ax\_grow}$ prevailing at the end of the growth phase, and the radial cooling temperature gradient $(\text{grad } T)_{rad\_cool}$ is at most 40%, in particular at most 30%, of the radial growth temperature gradient $(\text{grad } T)_{ax\_grow}$ prevailing at the end of the growth phase, in other words that the conditions of the above equations (1a) or (2a) and (4a) and of the above equations (1b) or (2b) and (4b) are satisfied. The axial cooling temperature gradient and the radial cooling temperature gradient are therefore very low, and so the annealing and cooling phase lasts longer than in the case of cooling without the additional cover 21. This has a positive effect with a view to reducing and homogenising the stress state and also the basal plane dislocation state in the previously grown SiC bulk monocrystal 19. At the end of the annealing and cooling phase, which is part of the overall growth process for the SiC bulk monocrystal 19, the SiC bulk monocrystal 19 is of a very high quality, with few, homogeneously distributed stresses and basal plane dislocations.

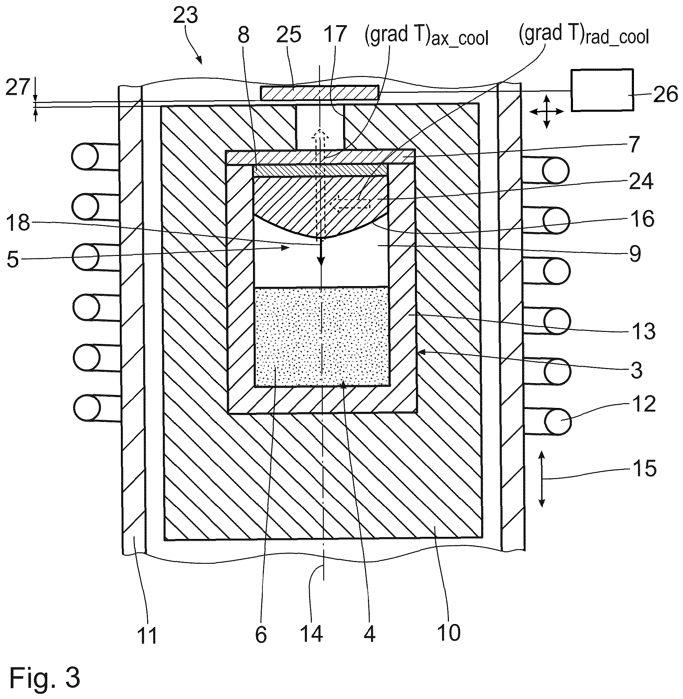

Fig. 3 shows an example embodiment of a further growth arrangement 23 for sublimation growth of an SiC bulk monocrystal 24. Like the growth arrangement 19 of Fig. 2, the growth arrangement 23 also has an additional cover 25, which again is a means for reducing and homogenising stresses and/or basal plane dislocations within the grown SiC bulk monocrystal 24. The basic difference from the growth arrangement 19 of Fig. 2 is that the additional cover 25 is not placed directly adjacent to the growth insulation 10, but rather can be placed at an axial distance 27 from the growth insulation 10 by means of a correspondingly configured control and adjustment mechanism 26. The axial distance 27 is in particular between 1 mm and 10 mm. Otherwise, the structure and mode of operation of the additional cover 25 are the same as those of the additional cover 21.

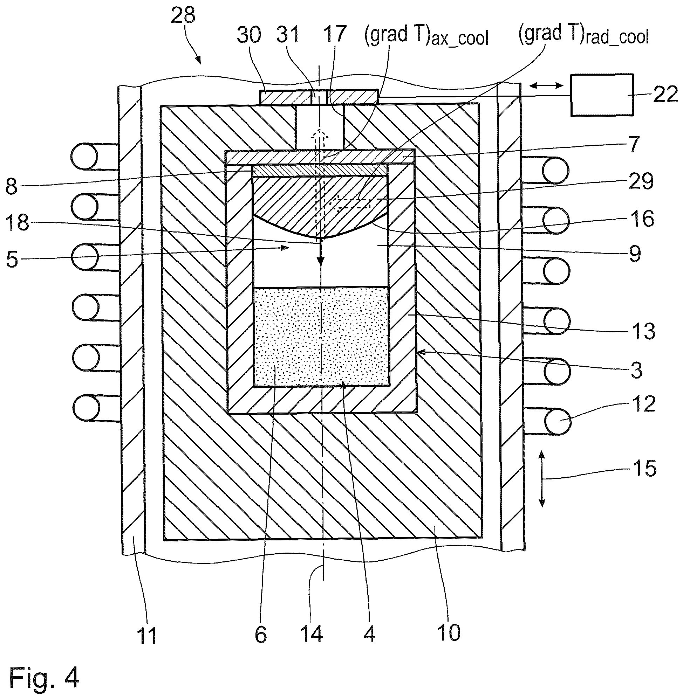

Fig. 4 shows an example embodiment of a further growth arrangement 28 for sublimation growth of an SiC bulk monocrystal 29. Like the growth arrangements 19 and 23 of Fig. 1 and 2 respectively, the growth arrangement 28 also has an additional cover 30, which again is a means for reducing and homogenising stresses and/or basal plane dislocations within the grown SiC bulk monocrystal 29. The basic difference from the growth arrangement 19 of Fig. 2 is that the additional cover 30 has a central cover opening 31 extending completely through the additional cover 30 axially. Its cross-sectional area is in particular 10% to 30% of the cross-sectional area of the insulation opening 17. The additional cover 30 can be positioned, by means of the control and adjustment mechanism 22, in such a way that the central cover opening 31 and the insulation opening 17 are arranged concentric with one another and in particular also with the central crystal longitudinal axis 14, and are aligned with one another, and that the additional cover 30 rests directly on the growth insulation 10. In an alternative example embodiment (not shown), the additional cover 30 may also be placed axially at a distance from the growth insulation 10. Otherwise, the structure and mode of operation of the additional cover 30 are the same as for the additional covers 21 and 25.

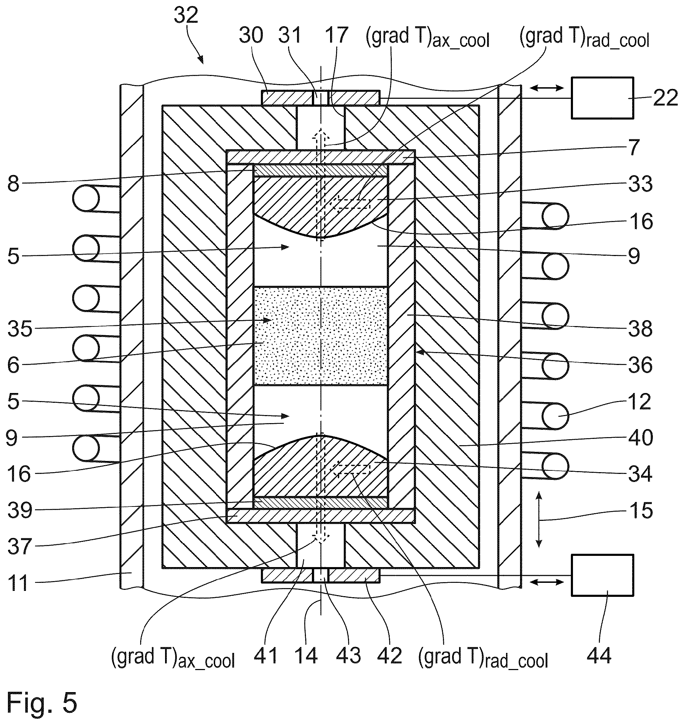

Fig. 5 shows an example embodiment of a further growth arrangement 32 for sublimation growth of two SiC bulk monocrystals 33 and 34. The growth arrangement 32 is substantially obtained by doubling up the growth arrangement 28, namely by axially mirroring the growth arrangement 28 downwards. In the growth arrangement 32, most components are the same as in the growth arrangement 28, and therefore also have like reference numerals. This also applies to the second sub-arrangement, which is mirrored downwards. In the following, only the components which are configured differently from in the growth arrangement 28 because of the doubling up will be described in greater detail.

An SiC reservoir region 35, which contains SiC source material 6 and feeds both of the SiC bulk monocrystals 33 and 34 to be grown, is arranged axially centrally in a growth crucible 36. In addition to the upper crucible end wall 7, the growth crucible 36 has a comparable lower crucible end wall 37 and a hollow cylindrical crucible side wall 38. Just as the upper crucible end wall 7 supports the SiC seed crystal 8, onto which the first SiC bulk monocrystal 34 grows, the lower crucible end wall 37 supports an SiC seed crystal 39, onto which the second SiC bulk monocrystal 34 grows. The sub-arrangements for growing the two SiC bulk monocrystals 33 and 34 are arranged aligned one above the other, in such a way that the same central crystal longitudinal axis 14 applies to both SiC bulk monocrystals 33 and 34 and is also the central longitudinal axis of the growth arrangement 32.

A thermal growth insulation 40 surrounding the growth crucible 36 has, in addition to the upper insulation opening 17 adjacent to the upper crucible end wall 7, an analogous lower insulation opening 41 adjacent to the lower crucible end wall 37. Furthermore, an additional cover 42 with a central cover opening 43 is provided, and can be placed in the region of the lower insulation opening 41. The additional cover 42 can be positioned, by means of a control and adjustment mechanism 44, in such a way that the central cover opening 43 and the lower insulation opening 41 are arranged concentric with one another and in particular also with the central crystal longitudinal axis 14, and are aligned with one another, and that the additional cover 42 rests directly against the growth insulation 40. The additional cover 42 is again a means of reducing and homogenising stresses and/or basal plane dislocations within the lower grown SiC bulk monocrystal 34. The additional cover 42 provided for the lower axial end face is structurally identical to the additional cover 30 provided for the upper axial end face. Otherwise, the structure and mode of operation of the additional covers 30 and 42 are the same as for the additional covers 21 and 25.

All additional covers 21, 25, 30 and 42 are switchable measures for the annealing and cooling phase, which serve to bring about the annealing effect described above during the cooling process and thus to improve the quality of the associated grown SiC bulk monocrystal 20, 24, 29, 33 or 34.

Growth arrangements 19, 23, 28 and 32 can be used in particular to carry out the growth processes referred to in the general part of the description.

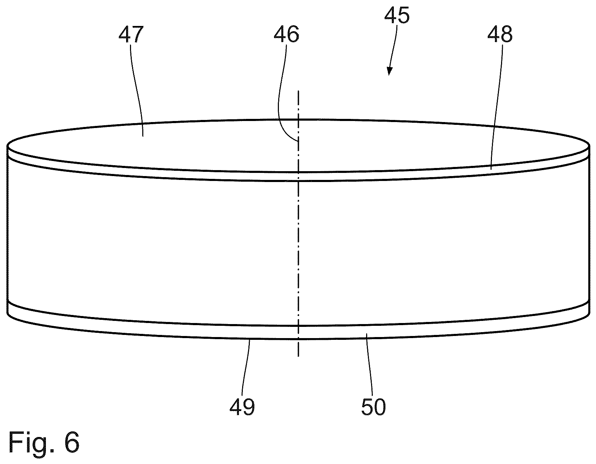

Fig. 6 shows an example embodiment of a monocrystalline SiC base body 45 produced from one of the SiC bulk crystals 20, 24, 29, 33 and 34. The SiC base body 45 is produced by trimming and/or grinding and/or polishing individual or all edge faces. The resulting monocrystalline SiC base body 45 of Fig. 6 is exactly circular-cylindrical and has a central base body longitudinal axis 46. There is also an alternative example embodiment (not shown in the drawings) in which the SiC base body is not exactly circular-cylindrical, but rather has an additional orientation marker, for example in the form of a flat or a notch. Monocrystalline SiC substrates for manufacturing semiconductor and/or high-frequency components can be obtained from the monocrystalline SiC base body 45 by axially successive cutting of thin slices.

Fig. 6 also shows an upper monocrystalline SiC substrate 48, separable from the monocrystalline SiC base body 45 at the upper end face 47, and a lower monocrystalline SiC substrate 50, separable from the monocrystalline SiC base body 45 at the lower end face 49. The monocrystalline SiC base body 45 has an advantageously homogeneous distribution of the basal plane dislocations in the axial direction. The upper monocrystalline SiC substrate 48 has an upper basal plane dislocation density, and the lower monocrystalline SiC substrate 48 has a lower basal plane dislocation density, the upper basal plane dislocation density and lower basal plane dislocation density differing from one another by at most 25%. This very low deviation between basal plane dislocation densities at the upper and the lower axial end face 47 and 49 is due to the advantageous homogenisation of the basal plane dislocations during the annealing and cooling phase in the growth process of the underlying SiC bulk monocrystal 20, 24, 29, 33 or 34.

Furthermore, the monocrystalline SiC base body 45 also has an advantageously homogeneous stress distribution in the axial direction. Stresses in the SiC crystal lattice can lead to bending (bowing) and/or curving (warping) of monocrystalline SiC substrates separated from the monocrystalline SiC base body 45.

The upper monocrystalline SiC substrate 48 has a first bow and the lower monocrystalline SiC substrate 50 has a second bow, the first bow and the second bow differing from one another by at most 25% because of the advantageous stress homogenisation during the annealing and cooling phase in the growth process of the underlying SiC bulk monocrystal 20, 24, 29, 33 or 34. The same applies to the curvatures. The upper monocrystalline SiC substrate 48 has a first warp and the lower monocrystalline SiC substrate 50 has a second warp, the first warp and the second warp differing from one another by at most 25% because of the advantageous stress homogenisation during the annealing and cooling phase in the growth process of the underlying SiC bulk monocrystal 20, 24, 29, 33 or 34.

Overall, the monocrystalline SiC base body 45 is of very high quality because of the advantageous growth process and is very suitable for producing equally high-quality monocrystalline SiC substrates for semiconductor and/or high-frequency components.

**Claims**

1. Process for producing at least one SiC bulk monocrystal (20; 24; 29; 33, 34) by sublimation growth, wherein

   a) prior to the start of the growth, at least one SiC seed crystal (8; 39) is arranged in at least one crystal growth region (5) of a growth crucible (3; 36), and SiC source material (6) is introduced into an SiC reservoir region (4; 35) of the growth crucible (3; 36),
   b) during a growth phase an SiC growth gas phase (9) is generated in the at least one crystal growth region (5) by sublimating the SiC source material (6) and transporting the sublimated gaseous components there, and the at least one SiC bulk monocrystal (20; 24; 29; 33, 34) having a central crystal longitudinal axis (14) grows on the at least one SiC seed crystal (8; 39) by deposition from the SiC growth gas phase (9),
   **characterised in that**
   c) during an annealing and cooling phase, carried out in the growth crucible after the growth phase is complete, the previously grown at least one SiC bulk monocrystal (20; 24; 29; 33, 34) is cooled, wherein an axial cooling temperature gradient measured in the direction of the central crystal longitudinal axis (14) is provided within the at least one SiC bulk monocrystal (20; 24; 29; 33, 34), and an axial quotient of the axial cooling temperature gradient and an axial growth temperature gradient, prevailing within the at least one grown SiC bulk monocrystal (20; 24; 29; 33, 34) at the end of the previous growth phase and also measured in the direction of the central crystal longitudinal axis (14), has at most an axial comparison value of 0.4.

2. Process according to Claim 1, **characterised in that** the axial cooling temperature gradient is provided in such a way that the axial quotient of the axial cooling temperature gradient and the axial growth temperature gradient prevailing within the at least one grown SiC bulk monocrystal (20; 24; 29; 33, 34) at the end of the preceding growth phase has at most an axial comparison value of 0.3.

3. Process according to either Claim 1 or Claim 2, **characterised in that** the axial cooling temperature gradient is provided in such a way that the axial quotient of the axial cooling temperature gradient and the axial growth temperature gradient in each 1 cm$^3$ sub-volume within the at least one SiC bulk monocrystal (20; 24; 29; 33, 34) is at most the axial comparison value.

4. Process according to any of the preceding claims, **characterised in that** the axial cooling temperature gradient is provided in such a way that it is at least 2 K/cm and in particular at most 6 K/cm.

5. Process according to any of the preceding claims, **characterised in that** during the annealing and cooling phase a radial cooling temperature gradient measured perpendicular to the central crystal longitudinal axis (14) is provided within the at least one SiC bulk monocrystal (20; 24; 29; 33, 34), and a radial quotient of the radial cooling temperature gradient and a radial growth temperature gradient prevailing within the at least one grown SiC bulk monocrystal (20; 24; 29; 33, 34) at the end of the preceding growth phase and also measured perpendicular to the central crystal longitudinal axis (14) has a radial comparison value of at most 0.4 and in particular a radial comparison value of at most 0.3.

6. Process according to Claim 5, **characterised in that** the radial cooling temperature gradient is provided in such a way that the radial quotient of the radial cooling temperature gradient and the radial growth temperature gradient in each 1 cm$^3$ sub-volume within the at least one SiC bulk monocrystal (20; 24; 29; 33, 34) is at most the radial comparison value.

7. Process according to either Claim 5 or Claim 6, **characterised in that** the radial cooling temperature gradient is provided in such a way that it is at least 0.25 K/cm and in particular at most 2 K/cm.

8. Process according to any of the preceding claims, **characterised in that** a central crystal length of 30 mm to 60 mm, in particular of 35 mm to 50 mm, measured along the central crystal longitudinal axis (14), is provided for the at least one SiC bulk monocrystal (20; 24; 29; 33, 34).

9. Process according to any of the preceding claims, **characterised in that,** after the growth phase is complete, as a measure to reduce stresses within the previously grown at least one SiC bulk monocrystal (20; 24; 29; 33, 34), the previously used growth arrangement (19; 23; 28; 32) is modified by placing an additional cover (21; 25; 30; 42) adjacent to the end face of a growth insulation (10; 40) surrounding the growth crucible (3; 36).

10. Process according to Claim 9, **characterised in that** the additional cover (21; 30; 42) is placed directly adjacent to the growth insulation (10; 40).

11. Process according to Claim 9, **characterised in that** the additional cover (25) is placed at a distance from the growth insulation (10), and an axial distance (27) from the growth insulation (10) is in particular between 1 mm and 10 mm.

12. Process according to any of Claims 9 to 11, **characterised in that** a configuration of the additional cover is provided in which the additional cover (30; 42) has a central cover opening (31; 43) extending completely through the additional cover (30; 42) axially, and the central cover opening (31; 43) has a cross-sectional area having a quotient of in particular between 0.1 and 0.3 with a cross-sectional area of an insulation opening (17; 41) located at the end face in the growth insulation (10; 40).

13. Process according to any of Claims 9 to 12, **characterised in that** a configuration of the additional cover is provided in which the additional cover has at least two cover openings extending completely through the additional cover axially, and each cover opening has an associated cross-sectional area, a quotient of the sum of the cross-sectional areas of all cover openings and the cross-sectional area of the insulation opening located at the end face of the growth insulation being in particular between 0.1 and 0.3.

14. Process according to any of the preceding claims, **characterised in that,** between the growing phase and the annealing and cooling phase, an annealing and holding phase is carried out, during which an annealing and holding temperature is set which is at least as high as the growth temperature set during the growing phase and in particular is at most 250°C higher than the growth temperature.

15. Monocrystalline SiC base body (45) produced from a sublimation-grown SiC bulk monocrystal (20; 24; 29; 33, 34) and intended for separating a plurality of monocrystalline SiC substrates from the monocrystalline SiC base body (45), wherein

a) the monocrystalline SiC base body (45) has a shape which, at least in a sub-region, is that of a cylinder, in particular circular cylinder, and

b) an upper monocrystalline SiC substrate (48), separable from the monocrystalline SiC base body (45) at the upper end face (47), has an upper basal plane dislocation density, and a lower monocrystalline SiC substrate (50), separable from the monocrystalline SiC base body (45) at the lower end face (49), has a lower basal plane dislocation density, the upper basal plane dislocation density and the lower basal plane dislocation density differing from one another by at most 25%.

Fig. 1

Fig. 2

Fig. 3

Fig. 4

Fig. 5

Fig. 6

Europäisches
Patentamt
European
Patent Office
Office européen
des brevets

# EUROPEAN SEARCH REPORT

**Application Number**

EP 25 22 3638

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 767 022 B1 (GUPTA AVINASH K [US] ET AL) 3 August 2010 (2010-08-03) | 1-8,14, 15 | INV.<br>C30B23/00 |
| Y | * figure 2 *<br>* column 10, line 34 - column 11, line 2 * | 9-13 | C30B23/06<br>C30B29/36 |
| | ----- | | |
| X | US 2018/282902 A1 (NAKABAYASHI MASASHI [JP]) 4 October 2018 (2018-10-04)<br>* example comparative 1 *<br>* table 5 * | 15 | |
| | ----- | | |
| Y | US 9 340 898 B2 (CHEN XIAOLONG [CN]; WANG BO [CN] ET AL.) 17 May 2016 (2016-05-17)<br>* figures 2-7 *<br>* column 5, line 64 - column 6, line 59 * | 9-13 | |
| | ----- | | |
| A | US 2016/083865 A1 (SAKURADA TAKASHI [JP] ET AL) 24 March 2016 (2016-03-24)<br>* figures 1-9 *<br>* paragraphs [0040] - [0042], [0045] - [0047], [0054], [0058] * | 1-15 | |
| | ----- | | |

**TECHNICAL FIELDS SEARCHED (IPC)**

C30B

The present search report has been drawn up for all claims

| Place of search | Date of completion of the search | Examiner |
|---|---|---|
| The Hague | 12 May 2026 | Schmitt, Christian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
    ...........................................................................
& : member of the same patent family, corresponding
    document

EPO FORM 1503 03.82 (P04C01)

# EP 4 779 063 A1

## ANNEX TO THE EUROPEAN SEARCH REPORT
## ON EUROPEAN PATENT APPLICATION NO.

EP 25 22 3638

12-05-2026

| Patent document cited in search report | | | Publication date | Patent family member(s) | | | Publication date |
|---|---|---|---|---|---|---|---|
| US 7767022 | B1 | | 03-08-2010 | NONE | | | |
| US 2018282902 | A1 | | 04-10-2018 | CN | 108138359 | A | 08-06-2018 |
| | | | | JP | WO2017057742 | A1 | 19-07-2018 |
| | | | | US | 2018282902 | A1 | 04-10-2018 |
| | | | | WO | 2017057742 | A1 | 06-04-2017 |
| US 9340898 | B2 | | 17-05-2016 | CN | 102534805 | A | 04-07-2012 |
| | | | | EP | 2653591 | A1 | 23-10-2013 |
| | | | | JP | 5450895 | B2 | 26-03-2014 |
| | | | | JP | 2013529175 | A | 18-07-2013 |
| | | | | US | 2013269598 | A1 | 17-10-2013 |
| | | | | WO | 2012079439 | A1 | 21-06-2012 |
| US 2016083865 | A1 | | 24-03-2016 | NONE | | | |

**EP 4 779 063 A1**

**Patent documents cited in the description**

- EP 25152093 A
- US 8865324 B2
- DE 102009048868 B4
- US 8449671 B2